# EUROPÄISCHE PATENTSCHRIFT

(11) **EP 2 054 949 B1**
(45) Veröffentlichungstag und Bekanntmachung des Hinweises auf die Patenterteilung: **25.01.2017**
(21) Anmeldenummer: 07817805.0
(22) Anmeldetag: 16.11.2007
(51) Int. Cl.: H01L 33/56, H01L 33/44

(54) **OPTOELEKTRONISCHES HALBLEITERBAUELEMENT**
OPTOELECTRONIC SEMICONDUCTOR COMPONENT
COMPOSANT SEMI-CONDUCTEUR OPTOÉLECTRONIQUE

(30) Priorität: 19.12.2006 DE 102006059994
(43) Veröffentlichungstag der Anmeldung: 06.05.2009
(73) Patentinhaber: OSRAM Opto Semiconductors GmbH, 93055 Regensburg (DE)
(72) Erfinder: WEBER-RABSILBER, Sven, 93073 Neutraubling (DE); GRUBER, Stefan, 93077 Bad Abbach (DE)
(74) Vertreter: Epping - Hermann - Fischer
(86) Internationale Anmeldenummer: PCT/DE2007/002091
(87) Internationale Veröffentlichungsnummer: WO 2008/074286

(56) Entgegenhaltungen:
- EP-A- 1 592 074
- EP-A2- 2 485 285
- US-A- 5 137 844
- US-A1- 2003 211 804
- US-A1- 2004 080 264
- US-A1- 2006 234 409
- US-B1- 6 345 903

## Beschreibung

Die Erfindung betrifft ein optoelektronisches Halbleiterbauelement mit einem Grundkörper, mindestens einem darauf angeordneten Halbleiterchip und einer den mindestens einen Halbleiterchip einbettenden Umhüllung aus einem strahlungsdurchlässigen Material mit Streupartikeln.

Optoelektronische Halbleiterbauelemente werden beispielsweise in einem Bereich der Anzeigentechnik eingesetzt, wo ein homogen ausgeleuchtetes und kontrastreiches Bild wichtig ist.

Bei einem Herstellungsverfahren für herkömmliche optoelektronische Halbleiterbauelemente der genannten Art wird zunächst ein vorgefertigter Leiterrahmen (Leadframe) mit einem geeigneten Kunststoffmaterial umspritzt, das einen Grundkörper für das Gehäuse des Bauteils bildet. Der Grundkörper weist an der Oberseite eine Ausnehmung auf, in die von zwei gegenüberliegenden Seiten Anschlüsse des Leiterrahmens eingeführt sind. Auf einem Anschluss wird der Halbleiterchip, beispielsweise ein LED-Chip oder eine Laserdiode, aufgeklebt und elektrisch kontaktiert. In die Ausnehmung wird dann eine in der Regel strahlungsdurchlässige Vergussmasse eingefüllt, die den Halbleiterkörper einbettet. Diese Grundform eines oberflächenmontierbaren optoelektronischen Halbleiterbauelements ist beispielsweise aus dem Artikel "SIEMENS SMT-TOPLED für die Oberflächenmontage", F. Möllmer und G. Waitl, Siemens Components 29 (1991), Heft 4, Seiten 147-149, bekannt.

Um beispielsweise bei einem Video-Display ein möglichst homogen ausgeleuchtetes und möglichst kontrastreiches Bild zu erzeugen, werden als Lichtquellen optoelektronische Halbleiterbauelemente eingesetzt, deren Grundkörper gesamt diffus reflektierend sind, also weiß erscheinen, oder Grundkörper deren Randbereich dunkel bedruckt ist, und der restliche Grundkörper weiß bleibt. Durch eine dunkle Ausbildung des Grundkörpers der Halbleiterbauelemente wird ein kontrastreiches Bild erzeugt. Der Kontrast kann durch Fremdlichteinfall heruntergesetzt werden, da das Fremdlicht an der Emissionsfläche des Halbleiterbauelements und der Chipoberfläche reflektiert wird. Beispielsweise sinkt der Kontrast mit steigender Helligkeit des Umgebungslichtes und das angezeigte Bild erscheint ausgebleicht.

Enthält die Vergussmasse der Halbleiterbauelemente auch Streupartikel, so ist die Emissionsfläche diffus reflektierend. Durch den Einsatz von vor die optoelektronischen Halbleiterbauelemente vorgeschalteten Blendenvorrichtungen und/oder Diffusorplatten können der Kontrast und die Homgogenität des Bildes weiter optimiert werden. Diese Vorrichtungen führen allerdings auch zu einem Lichtverlust, so dass das vom Halbleiterchip emittierte Licht eine höhere Helligkeit haben muss.

Das Dokument US 6 345 903 B1 offenbart ein optoelektronisches Halbleiterbauelement mit einem auf einem Grundkörper angeordneten Halbleiterchip und einer den Halbleiterchip einbettenden Umhüllung aus einem strahlungsdurchlässigen Material mit Streupartikeln und einer auf die Umhüllung aufgebrachten strahlungsdurchlässigen Deckschicht mit einem Absorber.

Aufgabe der Erfindung ist es daher, ein optoelektronisches Halbleiterbauelement anzugeben, so dass das vom Halbleiterchip emittierte Licht als homogene Leuchtfläche erscheint und das Halbleiterbauelement ein kontrastreiches Bild ermöglicht.

Diese Aufgabe wird durch ein optoelektronisches Halbleiterbauelement der eingangs genannten Art gelöst, das dadurch gekennzeichnet ist, dass auf die Umhüllung eine strahlungsdurchlässige Deckschicht mit einem Absorber aufgebracht ist.

Die erfindungsgemäßen optoelektronischen Halbleiterbauelemente erzeugen ein homogen ausgeleuchtetes und kontrastreiches Bild auf einem Video-Display, wobei die einzelnen Bildpunkte über die gesamte ihnen zur Verfügung stehende Pixelfläche homogen ausgeleuchtet erscheinen, also nicht als kleiner Spot der durch den Halbleiterchip erzeugt wird. Auch die Randbereiche beziehungsweise heruntergedimmte oder ausgeschaltete Bereiche des Bildes erscheinen schwarz. Durch das Aufbringen der strahlungsdurchlässigen Deckschicht mit dem Absorber wird der Anteil von einfallendem Fremdlicht minimiert und dadurch das kontrastreiche Bild auch bei steigender Helligkeit des Umgebungslichtes erzeugt. Durch die Streupartikel im strahlungsdurchlässigen Material der Umhüllung erscheint das vom Halbleiterchip emittierte Licht als homogene große Leuchtfläche.

Durch die Trennung in zwei Schichten, nämlich die Streupartikel enthaltende Umhüllung und die Absorber enthaltende Deckschicht, die auf die Umhüllung aufgebracht ist, hat eine Streupartikeldichte in der Umhüllung keinen Einfluss auf die Absorptionswirkung der Deckschicht. Der Vorteil ist, dass der Absorberanteil in der Deckschicht bei steigender Streupartikeldichte nicht erhöht werden muss, um den gleichen Kontrast zu erhalten. Der Absorptionsverlust des emittierten Lichtes wird somit gering gehalten. Ein weiterer Vorteil ist, dass bei einem erhöhten Kontrast, die Helligkeit des emittierten Lichtes gleich bleibt. Das heißt, dass die Anforderungen an die Helligkeit des optoelektronischen Halbleiterbauelementes bei erhöhtem Kontrast somit verringert ist. Des Weiteren können kontrastverbessernde Elemente, die vor die Halbleiterbauelemente vorgeschaltet werden, entfallen, beispielsweise ist das ein Rahmen zur Abschirmung vor einfallendem Umgebungslicht.

In einer weiteren vorteilhaften Ausführungsform ist der Grundkörper aus einem Material hergestellt, das für eine vom Halbleiterchip emittierte Strahlung zumindest teilweise absorbierend ist. Der Grundkörper ist beispielsweise aus einem dunklen oder schwarzen Kunststoff gefertigt. Damit wird ein guter Kontrast zwischen der Emissionsfläche des Bauelements und der übrigen Vorrichtungsfläche erzielt.

Weitere vorteilhafte Ausgestaltungen der Erfindung sind in den Unteransprüchen angegeben.

Die Erfindung wird nachfolgend anhand von Ausführungsbeispielen näher erläutert. Es zeigt:
Figur 1 eine schematische Querschnittsdarstellung eines ersten Bauelements,
Figur 2 eine schematische Querschnittsdarstellung eines zweiten Bauelements und
Figur 3 eine schematische Querschnittsdarstellung eines dritten Bauelements.

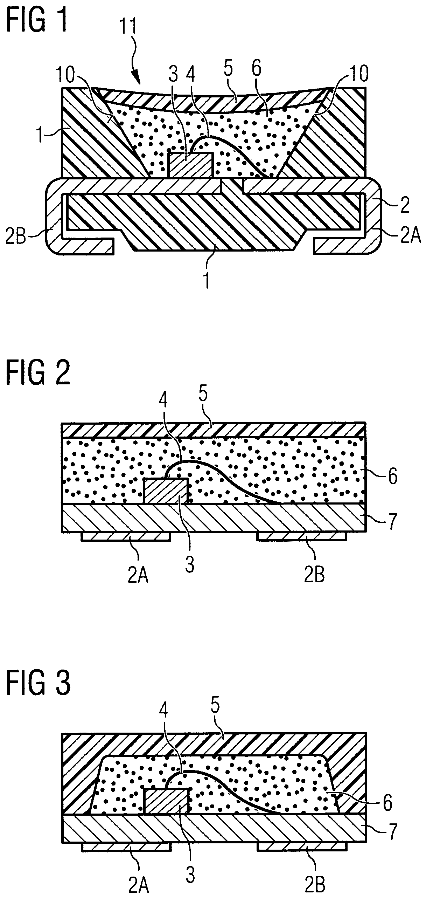

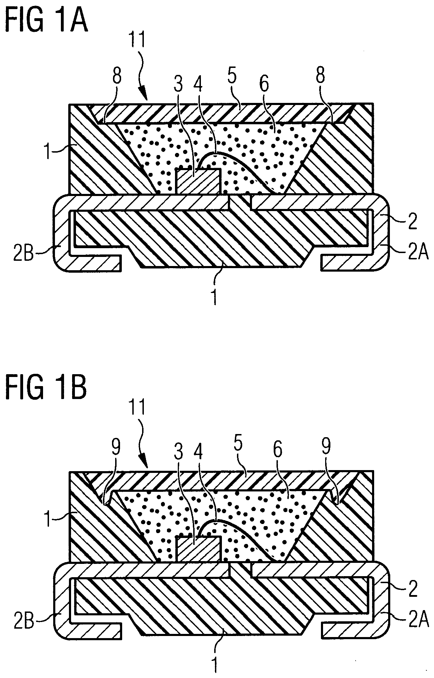

Die Figuren 1 bis 3 zeigen Beispiele eines optoelektronischen Halbleiterbauelements in Oberflächenmontagetechnik (SMT), wobei gleiche Teile des Halbleiterbauelements in den Figuren mit den gleichen Bezugszeichen gekennzeichnet sind.

Figur 1 zeigt eine schematische Querschnittsansicht eines optoelektronischen Halbleiterbauelements gemäß einem ersten Beispiel

Der Grundkörper 1 für das Halbleiterbauelement wird durch Umspritzen eines Leiterrahmens 2 mit einem geeigneten Kunststoffmaterial unter Formung eines Gehäuses gebildet. Der Grundkörper 1 weist eine mittige Ausnehmung auf, in der ein Halbleiterchip 3 wie zum Beispiel ein optoelektronischer Sender oder Empfänger angeordnet und mit den elektrischen Anschlüssen 2A, 2B des Leiterrahmens 2 mittels Bonddrahttechnik 4 elektrisch leitend verbunden wird.

Eine Innenfläche 10 der Ausnehmung des Grundkörpers 1 ist schräg ausgebildet und aus einem schwarzen Kunststoff gefertigt. Dadurch wird ein guter Kontrast zwischen einer Emissionsfläche 11 des Bauelements und der übrigen Vorrichtungsfläche des Grundkörpers 1 erzielt. Für den Grundkörper 1 wird beispielsweise ein Kunststoffmaterial, vorzugsweise ein thermoplastischer oder duroplastischer Kunststoff eingesetzt.

Der Halbleiterchip 3 ist in einer strahlungsdurchlässigen Umhüllung 6 eingebettet, die aus einer Vergussmasse mit Streupartikeln gefertigt ist. Die Füllhöhe der Umhüllung 6 schließt in diesem Ausführungsbeispiel unterhalb der Oberfläche des Grundkörpers 1 ab. Es wird aber darauf hingewiesen, dass im Rahmen der vorliegenden Erfindung je nach Bedarf selbstverständlich auch andere Füllhöhen der Umhüllung 6 in der Ausnehmung des Grundkörpers 2 gewählt werden können. Zwei solcher Beispiele sind in Figur 1A und 1B gezeigt.

Über der strahlungsdurchlässigen Umhüllung 6 mit Streupartikeln ist eine Deckschicht 5 mit Absorber aufgebracht, die eine strahlungsdurchlässige Vergussmasse mit Absorber ist. In diesem Ausführungsbeispiel schließt die Füllhöhe der Deckschicht 5 mit der Oberfläche des Grundkörpers 1 ab. Der Absorber in der Deckschicht 5 absorbiert von außen einfallendes Fremdlicht und verhindert somit ein Herabsetzen eines Kontrastes durch Reflexion des Fremdlichts an der Emissionsfläche 11 oder der Chipoberfläche. Es ist auch möglich die Deckschicht 5 als Plättchen auf die Umhüllung 6 aufzukleben.

Als Material für die Vergussmasse der Umhüllung 6 und der Deckschicht 5 wird beispielsweise ein Epoxidharz oder Silikon verwendet. Die Streupartikel in der Umhüllung 6 sind beispielsweise ein Aluminium-Oxid. Als Absorber in der Deckschicht 5 wird beispielsweise Ruß verwendet.

In Figur 1A ist ein Beispiel gezeigt, worin die Füllhöhe der Umhüllung 6 in der Ausnehmung des Grundkörpers 1 mit einer Stufe 8 in der Innenfläche 10 abschließt. Die Füllhöhe der Deckschicht 5, die auf die Umhüllung 6 aufgebracht wird, schließt mit der Oberfläche des Grundkörpers 1 ab. Die horizontale Ausdehnung der Deckschicht 5 ist größer als die an der Stufe abschließende horizontale Fläche der Umhüllung 6.

In Figur 1B ist ein Ausführungsbeispiel der Erfindung gezeigt, worin die Füllhöhe der Umhüllung 6 in der Ausnehmung des Grundkörpers 1 mit einer Welle 9 in der Innenfläche 10 abschließt. Die Füllhöhe der Deckschicht 5, die auf die Umhüllung 6 aufgebracht wird, schließt mit der Oberfläche des Grundkörpers 1 ab. Die horizontale Ausdehnung der Deckschicht ist größer als die an der Welle 9 abschließende horizontale Fläche der Umhüllung 6. In vertikaler Richtung beginnt die Füllhöhe in einem Randbereich der Deckschicht 5 unterhalb der Umhüllung 6.

Figur 2 zeigt in einem zweiten Beispiel eine schematische Querschnittsdarstellung eines optoelektronischen Halbleiterbauelements, dessen Grundkörper 1 durch ein Substrat 7 gebildet ist.

Der Halbleiterchip 3 ist auf dem Substrat 7 angeordnet und in einem zweischichtigen Körper eingebettet, nämlich der Umhüllung 6 mit Streupartikeln und der darauf aufgebrachten Deckschicht 5 mit Absorber. Der zweischichtige Körper ist auf das Substrat 7 aufgegossen oder aufgespritzt, wobei die Deckschicht 5 auf die Umhüllung 6 aufgegossen oder aufgespritzt ist.

Die Umhüllung 6 und die Deckschicht 5 sind aus Epoxidharz, Silikon oder Silikon-Epoxid-Hybrid gefertigt. Das Substrat 7 ist aus Keramik oder Epoxidharz mit Glasfasergewebe gefertigt, auch bekannt unter der Abkürzung FR4. Die Streupartikel in der Umhüllung 6 sind beispielsweise ein Aluminium-Oxid. Als Absorber in der Deckschicht 5 wird beispielsweise Ruß verwendet.

Es ist auch möglich, die Deckschicht 5 als Plättchen auf die Umhüllung 6 aufzudrucken oder aufzukleben.

Es ist möglich, die Deckschicht 5 über die Umhüllungen 6 mehrerer Halbleiterbauelemente zu kleben und zusammen mit den Halbleiterbauelementen voneinander zu trennen. Auch das Drucken der Deckschicht 5 auf die Umhüllungen 6 mehrerer Halbleiterbauelemente ist möglich. Allerdings müssen dann die Umhüllungen 6 eine ebene Fläche bilden.

Figur 3 zeigt in einem dritten Beispiel eine schematische Querschnittsdarstellung eines optoelektronischen Halbleiterbauelements, dessen Grundkörper 1 auch durch das Substrat 7 gebildet ist.

Der Halbleiterchip 3 ist auf dem Substrat 7 angeordnet und der Halbleiterchip 3 ist in dem zweischichtigen Körper eingebettet, nämlich der Umhüllung 6 mit Streupartikeln und der darauf aufgebrachten Deckschicht 5 mit Absorber.

Die Deckschicht 5 ist auf die Umhüllung 6 aufgegossen oder aufgespritzt. Dabei umhüllt die Deckschicht 5 mit Absorber die Umhüllung 6 mit Streupartikeln, wobei die Füllhöhe der Deckschicht 5 in diesem Ausführungsbeispiel bis zum Substrat 7 reicht. In das Halbleiterbauelement einfallendes Fremdlicht wird besonders effektiv abgeschirmt, wobei die Helligkeit des vom Halbleiterchip emittierten Lichtes nicht erhöht werden muss.

Es wird darauf hingewiesen, dass es auch möglich ist, den Halbleiterchip in eine Vergussmasse mit Streupartikeln einzubetten und in diese Vergussmasse Absorber beizugeben, ohne eine Deckschicht aufzubringen. Die Beigabe von Absorber hat allerdings den Nachteil, dass bei einem erhöhten Anteil von Streupartikeln auch die Absorberkonzentration hoch sein muss, um den gleichen Kontrast zu erreichen. Eine höhere Absorberkonzentration führt aber auch zu einer erhöhten Absorption des vom Halbleiterchip emittierten Lichts. Durch die Trennung in eine Umhüllung mit Streupartikeln und eine absorbierende Deckschicht, wie in den vorherigen Ausführungsbeispielen beschrieben, kann diese Wechselwirkung aufgehoben werden.

Die Erfindung ist nicht durch die Beschreibung anhand des Ausführungsbeispie ls beschränkt. Vielmehr umfasst die Erfindung jede Kombination von Merkmalen, die explizit in den Patentansprüchen angegeben ist.

## Patentansprüche

1. Optoelektronisches Halbleiterbauelement mit einem eine mittige Ausnehmung aufweisenden Grundkörper (1), mindestens einem auf dem Grundkörper in der Ausnehmung angeordneten Halbleiterchip (3) und einer den mindestens einen Halbleiterchip (3) einbettenden Umhüllung (6) aus einem strahlungsdurchlässigen Material mit Streupartikeln, bei dem eine Innenfläche der Ausnehmung des Grundkörpers schräg ausgebildet ist und auf die Umhüllung (6) eine strahlungsdurchlässige Deckschicht (5) mit einem Absorber aufgebracht ist,
**dadurch gekennzeichnet, dass**
der Grundkörper (1) eine Welle in der Innenfläche (10) des Grundkörpers (1) aufweist, wobei eine Füllhöhe der Umhüllung (6) in der Ausnehmung des Grundkörpers (1) mit der Welle (9) abschließt.

2. Optoelektronisches Bauelement nach Anspruch 1, bei dem der Grundkörper (1) aus einem Material hergestellt ist, das für eine von dem mindestens einen Halbleiterchip (3) emittierte Strahlung zumindest teilweise absorbierend ist.

3. Optoelektronisches Bauelement nach Anspruch 1 oder 2, bei dem der Absorber in der Deckschicht (5) für von außen einfallendes Fremdlicht absorbierend ist.

4. Optoelektronisches Bauelement nach Anspruch 1 oder 2, bei dem der Grundkörper (1) durch einen Leiterrahmen (2) gebildet ist, der mit einem Kunststoffmaterial umspritzt ist und der Grundkörper (1) an der Oberseite eine Ausnehmung aufweist.

5. Optoelektronisches Bauelement nach Anspruch 1 oder 2, bei dem der Grundkörper (1) durch ein Substrat (7) gebildet ist.

6. Optoelektronisches Bauelement nach Anspruch 1 oder 2, bei dem das Material der Deckschicht (5) aus Epoxidharz gefertigt ist und als Absorber Ruß aufweist.

7. Optoelektronisches Bauelement nach Anspruch 1 oder 2, bei dem das Material der Deckschicht (5) aus Silikon gefertigt ist und als Absorber Ruß aufweist.

8. Optoelektronisches Bauelement nach Anspruch 1 oder 2, bei dem das Material der Deckschicht(5) aus Silikon-Epoxid-Hybrid gefertigt ist und als Absorber Ruß aufweist.

9. Optoelektronisches Bauelement nach Anspruch 1, bei dem die strahlungsdurchlässige Deckschicht (5) als Plättchen ausgebildet ist, das auf die Umhüllung (6) aufgeklebt ist.

10. Optoelektronisches Bauelement nach Anspruch 1, bei dem die horizontale Ausdehnung der Deckschicht (5) größer ist als die an der Welle (9) abschließende horizontale Fläche der Umhüllung (6) und in vertikaler Richtung die Füllhöhe in einem Randbereich der Deckschicht (5) unterhalb der Umhüllung (6) beginnt.

## Claims

1. Optoelectronic semiconductor component comprising a basic body (1) which has a central cutout, at least one semiconductor chip (3) arranged on the basic body in the cutout, and an encapsulation (6) embedding the at least one semiconductor chip (3) and composed of a radiation-transmissive material with scattering particles, in which an inner area of the cutout of the basic body is embodied in oblique fashion and a radiation-transmissive covering layer (5) with an absorber is applied to the encapsulation (6), **characterized in that**
the basic body (1) has a wave in the inner area (10) of the basic body (1), wherein a filling level of the encapsulation (6) in the cutout of the basic body (1) terminates with the wave (9).

2. Optoelectronic component according to Claim 1,
in which the basic body (1) is produced from a material which is at least partly absorbent for a radiation emitted by the at least one semiconductor chip (3).

3. Optoelectronic component according to Claim 1 or 2, in which the absorber in the covering layer (5) is absorbent for externally incident extraneous light.

4. Optoelectronic component according to Claim 1 or 2, in which the basic body (1) is formed by a leadframe (2) around which a plastic material is injection-moulded, and the basic body (1) has a cutout at the top side.

5. Optoelectronic component according to Claim 1 or 2, in which the basic body (1) is formed by a substrate (7).

6. Optoelectronic component according to Claim 1 or 2, in which the material of the covering layer (5) is produced from epoxy resin and has carbon black as absorber.

7. Optoelectronic component according to Claim 1 or 2, in which the material of the covering layer (5) is produced from silicone and has carbon black as absorber.

8. Optoelectronic component according to Claim 1 or 2, in which the material of the covering layer (5) is produced from silicone-epoxide hybrid and has carbon black as absorber.

9. Optoelectronic component according to Claim 1,
in which the radiation-transmissive covering layer (5) is embodied as lamina which is adhesively bonded onto the encapsulation (6).

10. Optoelectronic component according to Claim 1, in which the horizontal extent of the covering layer (5) is greater than the horizontal area of the encapsulation (6) that terminates at the wave (9) and, in the vertical direction, the filling level begins in an edge region of the covering layer (5) below the encapsulation (6).

## Revendications

1. Composant semiconducteur optoélectronique comprenant un corps de base (1) qui possède une cavité centrale, au moins une puce en semiconducteur (3) disposée sur le corps de base dans la cavité et une enveloppe (6) qui enrobe l'au moins une puce en semiconducteur (3), constituée d'un matériau laissant passer le rayonnement avec des particules de dispersion, avec lequel une surface intérieure de la cavité du corps de base est de configuration inclinée et une couche de recouvrement (5) laissant passer le rayonnement comportant un absorbeur étant appliquée sur l'enveloppe (6), **caractérisé en ce que** le corps de base (1) possède une onde dans la surface intérieure (10) du corps de base (1), une hauteur de remplissage de l'enveloppe (6) dans la cavité du corps de base (1) se terminant avec l'onde (9).

2. Composant optoélectronique selon la revendication 1, avec lequel le corps de base (1) est fabriqué dans un matériau qui est au moins partiellement absorbant pour un rayonnement émis par l'au moins une puce en semiconducteur (3).

3. Composant optoélectronique selon la revendication 1 ou 2, avec lequel l'absorbeur dans la couche de recouvrement (5) est absorbant pour la lumière parasite incidente depuis l'extérieur.

4. Composant optoélectronique selon la revendication 1 ou 2, avec lequel le corps de base (1) est formé par un cadre conducteur (2) qui est surmoulé avec une matière plastique et le corps de base (1) possède une cavité sur le côté supérieur.

5. Composant optoélectronique selon la revendication 1 ou 2, avec lequel le corps de base (1) est formé par un substrat (7).

6. Composant optoélectronique selon la revendication 1 ou 2, avec lequel le matériau de la couche de recouvrement (5) est produit à partir de résine d'époxy et possède de la suie comme absorbeur.

7. Composant optoélectronique selon la revendication 1 ou 2, avec lequel le matériau de la couche de recouvrement (5) est produit à partir de silicone et possède de la suie comme absorbeur.

8. Composant optoélectronique selon la revendication 1 ou 2, avec lequel le matériau de la couche de recouvrement (5) est produit à partir d'hybride silicone époxy et possède de la suie comme absorbeur.

9. Composant optoélectronique selon la revendication 1, avec lequel la couche de recouvrement (5) laissant passer le rayonnement est réalisée sous la forme d'une plaquette qui est collée sur l'enveloppe (6).

10. Composant optoélectronique selon la revendication 1, avec lequel l'extension horizontale de la couche de recouvrement (5) est supérieure à la surface horizontale de l'enveloppe (6) qui se termine au niveau de l'onde (9) et, dans la direction verticale, la hauteur de remplissage commence dans une zone de bordure de la couche de recouvrement (5) au-dessous de l'enveloppe (6).
